# EUROPÄISCHE PATENTANMELDUNG

(11) **EP 2 399 770 A2**
(43) Veröffentlichungstag der Anmeldung: **28.12.2011**
(21) Anmeldenummer: 10192197.1
(22) Anmeldetag: 23.11.2010
(51) Int. Cl.: B60L 11/18

(54) **Vorrichtung zur Energiespeicherung**

(30) Priorität: 29.01.2010 DE 102010001374
(71) Anmelder: Siemens Aktiengesellschaft, 80333 München (DE)
(72) Erfinder: Peppel, Torsten, 14641 Wustermark (DE); Meinert, Michael, 91056 Erlangen (DE); Rechenberg, Karsten, 91077 Dormitz (DE)

(57) **Zusammenfassung**

Die Erfindung betrifft eine Vorrichtung zur Energiespeicherung, insbesondere zur Traktionsversorgung eines Schienenfahrzeugs, umfassend Speicherzellen (11) zum Laden und Entladen von elektrischer Energie. Die Speicherzellen (11) sind in einem Modulgehäuse (12) zu einem Speichermodul (10) angeordnet. Die Vorrichtung umfasst ferner eine Einrichtung (13) zur Überwachung einer Temperatur im Speichermodul (10). Erfindungsgemäß weist die Überwachungseinrichtung (13) je Speicherzelle (11) oder je Gruppe von Speicherzellen (11) einen Temperaturfühler (14) auf. Die Temperaturfühler (13) sind als temperaturabhängige elektrische Widerstände ausgebildet und zu einer elektrischen Messschaltung mit einem temperaturabhängigen elektrischen Gesamtwiderstand verschaltet. Die Überwachungseinrichtung (13) weist ferner eine Auswertungseinheit (17) auf, mittels der aus gemessenen Werten des Gesamtwiderstandes auf eine Verteilung der Betriebstemperaturen der Speicherzellen (11) schließbar ist. Hierdurch wird eine Temperaturüberwachung von einzelnen Speicherzellen (11) mit geringem messtechnischen Aufwand ermöglicht.

## Beschreibung

Die Erfindung bezieht sich auf eine Vorrichtung zur Energiespeicherung nach dem Oberbegriff des Patentanspruches 1.

Derartige Speichermodule umfassen eine Vielzahl an gestapelt angeordneten und elektrisch in Reihe und/oder parallel geschalteten elektrischen und/oder elektrochemischen Speicherzellen für elektrische Energie. Für die Traktionsversorgung von Fahrzeugen, insbesondere von Schienenfahrzeugen, eignen sich zum Beispiel besonders elektrische Doppelschichtkondensatoren und Lithium-Ionen-Batterien. Aufgrund von Alterung oder eines Defekts kann sich die Betriebstemperatur einer Speicherzelle wesentlich erhöhen. Zum Schutz der Speicherzelle und damit zur Gewährleistung der Sicherheit der gesamten Energiespeichervorrichtung ist es daher notwendig, ein Überschreiten einer kritischen Betriebstemperatur zu verhindern.

Zur Messung von Temperaturen innerhalb von Speichermodulen kommen Thermoelemente zum Einsatz, wobei nicht die Temperaturen einzelner Speicherzellen bestimmt werden, sondern die Temperaturen an vorher als kritisch diagnostizierten Stellen. Ein kritischer Betriebszustand einer einzelnen Speicherzelle wird dadurch nicht erkannt. Außerdem kann die Installation von Thermoelementen oder sonstigen Messeinrichtungen an den gewünschten Positionen teuer und unter bestimmten Umständen unzweckmäßig sein.

Aus der Offenlegungsschrift DE 10 2004 040 179 A1 ist ein Verfahren zum Steuern eines Fahrzeug-Energiespeichersystems bekannt, welches zur Reduzierung der Anzahl an Temperaturmesspunkten Modelle für die Speicherzellentemperatur nutzt. Demnach ist die Speicherzellentemperatur unter anderem von der Umgebungstemperatur, dem Umgebungsdruck, Betriebszuständen des Lüftungsgebläses, Strom und/oder Stromflusshistorie der Batterie-/Superkondensatorbank, Technologie und/oder Chemie der Batterie bzw. des Superkondensators sowie den Batteriekasteneigenschaften abhängig. Die anhand des thermischen Modells geschätzten Temperaturwerte werden zum Anpassen der geeigneten Steuerparameter des Energiespeichersystems verwendet.

Die Offenlegungsschrift DE 10 2008 009 970 A1 offenbart ein Batteriemanagementsystem mit einer Steuerungsvorrichtung für wiederaufladbare Energiespeichereinrichtungen aus galvanischen Zellen. Die Steuervorrichtung steuert beispielsweise die Ladung/Entladung angeschlossener galvanischer Zellen und greift in diese Vorgänge ein, um unerwünschte Zustände einzelner Zellen zu beseitigen. Dazu werden elektrische Spannungen, Temperaturen und/oder Ladungszustände angeschlossener galvanischer Zellen ermittelt und bewertet. Im Anschluss an die Bewertung greift die Steuervorrichtung ggf. korrigierend in Vorgänge ein. Hierzu sind Messeinrichtungen zur Erfassung von Funktionsparametern einer galvanischen Zelle, wie der elektrischen Spannung, des elektrischen Stroms, der elektrischen Ladung, aber auch der Temperatur einer galvanischen Zelle zu installieren. Um einer unerwünschten Temperatur einer galvanischen Zelle zu begegnen, kann die Steuereinrichtung beispielsweise eine Kühleinrichtung zu- oder abschalten.

Der Erfindung liegt daher die Aufgabe zugrunde, eine Energiespeichervorrichtung der eingangs genannten Art bereitzustellen, mit der auf einfache Weise ein hinsichtlich der Temperatur kritischer Betriebszustand des Speichermoduls bestimmt werden kann.

Die Aufgabe wird gelöst durch eine gattungsgemäße Vorrichtung zur Energiespeicherung mit den im kennzeichnenden Teil des Patentanspruches 1 angegebenen Merkmalen. Demnach weist die Überwachungseinrichtung je Speicherzelle oder je Gruppe von Speicherzellen einen Temperaturfühler auf. Die Temperaturfühler sind als temperaturabhängige elektrische Widerstände ausgebildet und zu einer elektrischen Messschaltung mit einem temperaturabhängigen elektrischen Gesamtwiderstand verschaltet. Die Verschaltung kann als Reihen- oder als Parallelschaltung erfolgen. Die Temperaturfühler sind als Kalt- oder Heißleiter mit positivem bzw. negativem Temperaturkoeffizienten ausgebildet. Ferner weist die Überwachungseinrichtung eine Auswertungseinheit auf, mittels der aus gemessenen Werten des Gesamtwiderstandes auf eine Verteilung der Betriebstemperaturen der Speicherzellen schließbar ist. Damit können Temperaturaussagen über einzelne Speicherzellen des Speichermoduls getroffen werden, etwa über elektrische Doppelschichtkondensatoren oder Batteriezellen, wobei der messtechnische Aufwand für die Temperaturmessung sehr gering ist. Diese kostengünstige Lösung erhöht die Verfügbarkeit erfindungsgemäßer Temperaturüberwachungseinrichtungen für Energiespeichervorrichtungen.

In einer vorteilhaften Ausführungsform der erfindungsgemäßen Energiespeichervorrichtung umfasst die Auswertungseinheit einen elektronischen Datenspeicher, worauf Gesamtwiderstandsverläufe in Abhängigkeit der Temperatur für charakteristische Betriebszustände des Speichermoduls gespeichert sind, wobei ein Betriebszustand durch die Anzahl an Speicherzellen mit erhöhter Betriebstemperatur und durch die jeweiligen Betriebstemperaturen charakterisiert ist, und Vergleichsmittel, die dazu ausgebildet sind, aus einem Vergleich des gemessenen Gesamtwiderstandes mit den gespeicherten Gesamtwiderstandsverläufen auf den Betriebszustand des Speichermoduls zu schließen. Auf diese Weise werden charakteristische Betriebszustände als Referenzzustände des Speichermoduls hinterlegt, mit welchen der gemessene Gesamtwiderstand der Messschaltung verglichen wird, um den aktuell vorliegenden Betriebszustand zu ermitteln.

In einer bevorzugten Ausgestaltung der erfindungsgemäßen Energiespeichervorrichtung weist die Überwachungseinrichtung wenigstens einen Temperatursensor auf, der zur Erfassung einer Modultemperatur des Speichermoduls ausgebildet und angeordnet ist. Die Kenntnis der vorherrschenden Modultemperatur erlaubt zusammen mit dem gemessenen Gesamtwiderstand der Messschaltung eine genauere Bestimmung des aktuell bestehenden Betriebszustandes des Speichermoduls. Der Temperatursensor kann beispielsweise als Pt100-Widerstandsthermometer ausgebildet sein. Wenn dieser ausfällt, kann die Modultemperatur auch aus einem anderen Speichermodul des Stranges, welches gleich belastet ist und sich im gleichen Kühlmittelkreislauf befindet wie das betrachtete, gewonnen werden und über ein Bussystem übertragen werden. Es können aber auch zwei als Pt100-Widerstandsthermometer ausgeführte Temperatursensoren im Speichermodul an vorbestimmten Positionen angeordnet sein, um eine Modultemperatur etwa durch Mittelwertbildung der beiden von den Temperatursensoren gemessenen Temperaturen zu erfassen.

In einer alternativen bevorzugten Ausgestaltung der erfindungsgemäßen Energiespeichervorrichtung ist auf dem elektronischen Datenspeicher ein Temperaturmodell gespeichert, mittels dessen die Auswertungseinheit aus einem gemessenen Gesamtwiderstand eine Modultemperatur des Speichermoduls ermittelt. Anhand eines hinterlegten Temperaturmodells, welches eine Vielzahl an den Wärmeaustausch innerhalb des Speichermoduls zwischen Speicherzellen, Modulgehäuse, Kühleinrichtung, und dergleichen beeinflussenden Umstände berücksichtigt, kann aus dem gemessenen Gesamtwiderstand der Messschaltung auf die Modultemperatur geschlossen werden.

In einer vorteilhaften Ausgestaltung der erfindungsgemäßen Energiespeichervorrichtung weist die Auswertungseinrichtung eine Ausgabeeinheit zur Ausgabe eines Vergleichsergebnisses auf, welches den jeweils erschlossenen Betriebszustand und, falls es sich um einen kritischen Betriebszustand handelt, eine Warnung umfasst. Die Ausgabeeinrichtung kann das Vergleichsergebnis entweder als analoges oder als digitales Signal ausgeben. Es kann enthalten, ob sich die Zellparameter im vorgeschriebenen Bereich befinden oder nicht. Erfolgt eine digitale Ausgabe, ist es auch möglich, die Ergebnisse unterschiedlicher Parameter wie zum Beispiel der Temperatur, der Spannung und des Druckes zu einem summarischen Signal pro Speichermodul zusammenzufassen.

So ist in einer bevorzugten Ausführungsform der erfindungsgemäßen Energiespeichervorrichtung die Auswertungseinheit mit einer Steuereinrichtung zur Steuerung des Lade- bzw. Entladevorganges der Speicherzellen und/oder zur Ansteuerung einer Kühleinrichtung für die Speicherzellen gekoppelt. In Abhängigkeit des Auswertungsergebnisses, also beispielsweise bei erhöhter Temperatur einer Speicherzelle oder bei geringem Ladungszustand, den die Steuereinrichtung über die Zellenspannung abgreifende Messbrücken ermittelt, kann die Kühlleistung der Kühleinrichtung erhöht werden oder der Ladungszustand über in Reihe geschaltete benachbarte Speicherzellen ausgeglichen werden.

Weitere Eigenschaften und Vorteile ergeben sich aus einem Ausführungsbeispiel der Erfindung, welches nachfolgend anhand von Zeichnungen näher beschrieben wird, in deren
- FIG 1: ein Schaltbild einer erfindungsgemäßen Energieversorgungsvorrichtung und
- FIG 2: ein Verlauf des Gesamtwiderstandes in Abhängigkeit der Temperatur für verschiedene Betriebszustände des Speichermoduls
schematisch veranschaulicht ist.

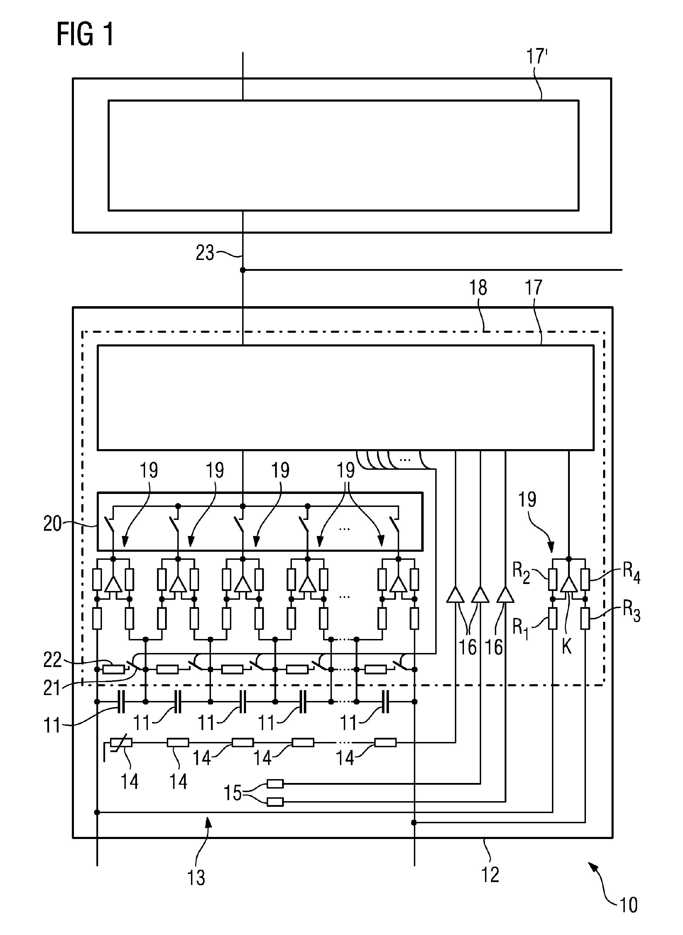

Gemäß FIG 1 umfasst eine Vorrichtung zur Energiespeicherung wenigstens ein Speichermodul 10 mit einem Modulgehäuse 12, in welchem eine Mehrzahl an Speicherzellen 11 zum Laden bzw. Entladen von elektrischer Energie angeordnet sind. Die Speicherzellen 11 können gestapelt angeordnet sein. In dem Speichermodul 10 können beispielsweise 24 als elektrische Doppelschichtkondensatoren ausgebildete Speicherzellen 11 angeordnet sein, während in einem nicht dargestellten zweiten Speichermodul die Speicherzellen beispielsweise als Nickel-Cadmium-Batteriezellen ausgebildet sein können. Eine derartige Hybrid-Energiespeichervorrichtung ist besonders für die Traktionsversorgung von Schienenfahrzeugen auf oberleitungslosen Fahrstrecken geeignet, wobei die elektrische Energie für den Antrieb des Schienenfahrzeugs in Beschleunigungsphasen aus dem Kondensator-Speichermodul 10 und sonst aus dem Batterie-Speichermodul gespeist werden kann. Beim Bremsen des Schienenfahrzeugs können beispielsweise die Speicherzellen 11 des Speichermoduls 10 durch Zuführen der im Antriebssystem zu elektrischer Energie gewandelten Bremsenergie wieder geladen werden. Beim Laden bzw. Entladen erzeugen die Speicherzellen 11 aufgrund ihres inneren ohmschen Widerstandes Wärmeenergie, die beispielsweise über eine nicht dargestellte Kühleinrichtung abgeführt werden muss, damit die Temperatur der Speicherzellen 11 innerhalb eines für ihren Betrieb optimalen Temperaturbereichs gehalten wird. Hierzu umfasst die Energiespeichervorrichtung eine Einrichtung 13 zur Messung der Temperatur im Speichermodul 10.

Die Temperaturmesseinrichtung 13 weist erfindungsgemäß eine Messschaltung von in Reihe geschalteten Temperaturfühlern 14 auf. In einer nicht dargestellten alternativen Ausführungsform können die Temperaturfühler auch parallel geschaltet sein. Die Temperaturfühler 14 sind als Kaltleiter - auch PTC-Widerstände genannt - ausgeführt, weisen also einen elektrischen Widerstand mit positivem Temperaturkoeffizienten auf. Alternativ können die Temperaturfühler auch als Heißleiter - auch NTC-Widerstände genannt - ausgeführt sein, deren elektrischer Widerstand mit zunehmender Temperatur fällt. Erfindungsgemäß ist jeder Speicherzelle 11 ein Temperaturfühler 14 zugeordnet, indem dieser direkt auf die Oberfläche der Speicherzelle 11 oder in deren unmittelbaren Umgebung angeordnet ist. Jedenfalls bestimmt die Temperatur einer Speicherzelle 11 den Wert des elektrischen Widerstands eines zugeordneten Temperaturfühlers 14. Der elektrische Gesamtwiderstand der Messschaltung hängt damit von den einzelnen Temperaturen der Speicherzellen 11 im Speichermodul 10 sowie von der Art der Messschaltung ab. Bei einer Reihenschaltung ergibt sich der Gesamtwiderstand aus der Summe der einzelnen Widerstände der Temperaturfühler 14. Alternativ kann ein Temperaturfühler 14 auch einer Gruppe von nebeneinander angeordneten Speicherzellen 11 zugeordnet sein.

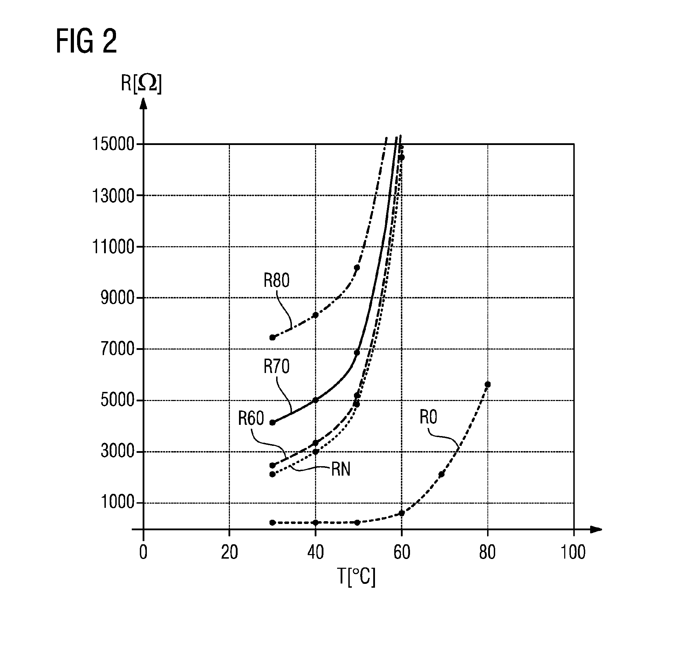

FIG 2 zeigt den temperaturabhängigen Widerstandsverlauf R0 eines einzelnen Temperaturfühlers 14 sowie den temperaturabhängigen Gesamtwiderstandsverlauf RN der Messschaltung sämtlicher vierundzwanzig in Reihe geschalteter Temperaturfühler 14, jeweils im Normalbetriebszustand. Der Verlauf des Gesamtwiderstandes ändert sich, sobald sich die Temperatur einer oder mehrerer Speicherzellen 11 erhöht. So zeigt FIG 2 beispielhaft temperaturabhängige Gesamtwiderstandsverläufe R60, R70 und R80 der Messschaltung, in der sich die Temperatur einer Speicherzelle 11 auf 60 °C, 70 °C beziehungsweise 80 °C erhöht hat, während die restlichen dreiundzwanzig Speicherzellen 11 eine normale Betriebstemperatur aufweisen. Die Gesamtwiderstandsverläufe R60, R70 und R80 sind somit charakteristischen Betriebszuständen des Speichermoduls 10 zugeordnet, die durch die Anzahl an Speicherzellen 11 mit erhöhter Betriebstemperatur und durch die jeweilige erhöhte Betriebstemperatur der Speicherzelle 11 charakterisiert sind.

Die Temperaturmesseinrichtung 13 der erfindungsgemäßen Energiespeichervorrichtung umfasst gemäß FIG 1 noch beispielsweise zwei Temperatursensoren 15, die im Speichermodul 12 zur Erfassung einer Modultemperatur angeordnet sind. Die Temperatursensoren 15 sind beispielsweise als Pt100-Widerstands-thermometer ausgeführt, wobei es sich um Platindrähte oder -schichten mit einem Nennwiderstand von 100 Ω bei einer Temperatur von 0 °C handelt, die einen positiven Temperaturkoeffizienten aufweisen. Anhand der Temperatursensoren 15 sind Modultemperaturen an zwei repräsentativen Positionen im Speichermodul 10 sowie deren Mittelwert erfassbar.

Die Messwerte des aktuellen Gesamtwiderstandes der Messschaltung 13 sowie die Messwerte der Temperatursensoren 15 werden mittels Verstärker 16 verstärkt einer Auswertungseinheit 17 zugeführt, die Teil einer Steuereinrichtung 18 der erfindungsgemäßen Energiespeichervorrichtung ist. Die Auswertungseinrichtung 17 umfasst nicht dargestellte Vergleichsmittel, mit deren Hilfe eine erfasste Modultemperatur T des Speichermoduls 10 und ein erfasster Gesamtwiderstand R der Messschaltung 13 mit charakteristischen Betriebszuständen des Speichermoduls 10 verglichen werden. Hierzu sind die Daten der Gesamtwiderstandsverläufe RN, R60, R70 und R80 auf einem in FIG 1 nicht dargestellten Datenspeicher der Auswertungseinheit 17 ausles- und überschreibbar abgelegt. Als Ergebnis der Auswertung erhält man, welcher der charakteristischen Betriebszustände vorliegt, oder in anderen Worten, ob Speicherzellen 11 eine erhöhte Betriebstemperatur aufweisen und wenn ja, beispielsweise wie viele und welche Temperatur diese aufweisen. Hierdurch liefert die erfindungsgemäße Temperaturmesseinrichtung 13 in Verbindung mit der Auswertungseinheit 17 eine detaillierte Auskunft über den Betriebszustand des Speichermoduls 10 mit im Vergleich zum Stand der Technik geringem messtechnischen Aufwand. Der geringe Aufwand sichert wiederum eine hohe Verfügbarkeit der Temperaturüberwachung.

Eine Auswertungseinrichtung 17' kann auch außerhalb des Speichermoduls 10 angeordnet und mittels eines Kommunikationsbusses 23, beispielsweise mittels eines CAN-Busses, mit der internen Auswertungseinrichtung 17 oder mit anderen Komponenten wie der Kühleinrichtung in Verbindung stehen.

Des Weiteren werden mittels einer Messbrücke 19 die vom Speichermodul 10 bereitgestellte Gesamtspannung sowie ebenfalls über je eine Messbrücke 19 die von jeder Speicherzelle 11 bereitgestellte Teilspannung gemessen und die Messwerte der Auswertungseinheit 17 zugeführt. Eine Messbrücke 19 weist zwei parallele Spannungsteiler mit je zwei hintereinander geschalteten elektrischen Widerständen R1 und R2 beziehungsweise R3 und R4 und einen Komparator K im H-Brückenzweig auf, dessen Ausgang zur Auswertungseinheit 17 führt. Durch eine Schalteinrichtung 20 können die Messbrücken 19 der Speicherzellen 11 gezielt einzeln zugeschaltet und deren Ladezustand abgefragt werden. Im Falle eines kritischen Betriebszustandes, bei dem Fehler in einer oder mehreren Speicherzellen 11 auftreten, wie etwa ein Ansteigen von Temperatur und Spannung oder ein Abfallen der elektrischen Ladung, können durch Schließen von Schaltern 21 Widerstände 22 zu den Speicherzellen 11 parallel geschaltet werden, über die ein Ladungsausgleich zwischen Speicherzellen 11 stattfinden kann. Dadurch können geschädigte Speicherzellen 11 eindeutig identifiziert werden. Außerdem können geschädigte Speicherzellen 11 gezielt teilentladen und damit deren Lebensdauer verlängert werden. Die Steuereinrichtung 20 kann bei Eintreten einer erhöhten Speicherzellentemperatur auch in den Betrieb einer in FIG 1 nicht dargestellten Kühleinrichtung nehmen, um beispielsweise bei Temperaturerhöhungen deren Kühlleistung zu steigern.

Die Ausgabe des Auswertungsergebnisses kann entweder als analoges oder digitales Signal erfolgen, beispielsweise dass sich die Zellenparameter im vorgeschriebenen Wertebereich liegen. Erfolgt eine digitale Ausgabe, ist es auch möglich, die Werte unterschiedlicher Parameter, wie zum Beispiel Temperatur, Spannung und Druck zu einem summarischen Signal pro Speichermodul zusammenzufassen.

Die erfindungsgemäße Energiespeichervorrichtung ermöglicht es, Fehler an einzelnen Speicherzellen 11 von Speichermodulen 10 sicher und sehr preiswert zu diagnostizieren. Dies ist insbesondere notwendig, da sich nicht alle Zellfehler, wie zum Beispiel diejenigen aufgrund der Alterung einer Speicherzelle 11, sicher durch die Messung von elektrischen Größen, wie zum Beispiel Strom und Spannung, diagnostizieren lassen.

## Patentansprüche

1. Vorrichtung zur Energiespeicherung, insbesondere zur Traktionsversorgung eines Schienenfahrzeugs, mit Speicherzellen (11) zum Laden und Entladen von elektrischer Energie, wobei die Speicherzellen (11) in einem Modulgehäuse (12) zu einem Speichermodul (10) angeordnet sind, und mit einer Einrichtung (13) zur Überwachung einer Temperatur im Speichermodul (10), **dadurch gekennzeichnet, dass** die Überwachungseinrichtung (13) je Speicherzelle (11) oder je Gruppe von Speicherzellen (11) einen Temperaturfühler (14), welche als temperaturabhängige elektrische Widerstände ausgebildet und zu einer elektrischen Messschaltung mit einem temperaturabhängigen elektrischen Gesamtwiderstand verschaltet sind, und eine Auswertungseinheit (17) aufweist, mittels der aus gemessenen Werten des Gesamtwiderstandes auf eine Verteilung der Betriebstemperaturen der Speicherzellen (11) schließbar ist.

2. Vorrichtung nach Anspruch 1,
wobei die Auswertungseinheit (17) einen elektronischen Datenspeicher, worauf Gesamtwiderstandsverläufe (RN, R60, R70, R80) in Abhängigkeit der Temperatur T für charakteristische Betriebszustände des Speichermoduls (10) gespeichert sind, wobei ein Betriebszustand durch die Anzahl an Speicherzellen (11) mit erhöhter Betriebstemperatur und durch die jeweiligen Betriebstemperaturen charakterisiert ist, und Vergleichsmittel umfasst, die dazu ausgebildet sind, aus einem Vergleich des gemessenen Gesamtwiderstandes (R) mit den gespeicherten Gesamtwiderstandsverläufen (RN, R60, R70, R80) auf den Betriebszustand des Speichermoduls (10) zu schließen.

3. Vorrichtung nach Anspruch 1 oder 2,
wobei die Überwachungseinrichtung (13) wenigstens einen Temperatursensor (15) aufweist, der zur Erfassung einer Modultemperatur (T) des Speichermoduls (10) ausgebildet und angeordnet ist.

4. Vorrichtung nach Anspruch 1 oder 2,
wobei auf dem elektronischen Datenspeicher ein Temperaturmodell gespeichert ist, mittels dessen die Auswertungseinheit (17) aus einem gemessenen Gesamtwiderstand (R) eine Modultemperatur (T) des Speichermoduls (10) ermittelt.

5. Vorrichtung nach einem der Ansprüche 1 bis 4,
wobei die Auswertungseinrichtung (17) eine Ausgabeeinheit zur Ausgabe eines Vergleichsergebnisses aufweist, welches den jeweils erschlossenen Betriebszustand und ggf. eine Warnung umfasst, falls es sich um einen kritischen Betriebszustand handelt.

6. Vorrichtung nach einem der Ansprüche 1 bis 5,
wobei die Auswertungseinheit (17) mit einer Steuereinrichtung (18) zur Steuerung des Lade- bzw. Entladevorganges der Speicherzellen (11) und/oder zur Ansteuerung einer Kühleinrichtung für die Speicherzellen (11) gekoppelt ist.
